(19) Europäisches Patentamt
European Patent Office
Office européen des brevets

(11) **EP 4 723 481 A2**

(12) **EUROPEAN PATENT APPLICATION**

(43) Date of publication:
08.04.2026 Bulletin 2026/15

(51) International Patent Classification (IPC):
**H03K 17/042** *(2006.01)* **H03K 17/16** *(2006.01)*

(21) Application number: 25202256.1

(52) Cooperative Patent Classification (CPC):
**H03K 17/04206; H03K 17/166**

(22) Date of filing: **15.09.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **02.10.2024 US 202418904733**

(71) Applicant: **Analog Devices, Inc.**
**Wilmington, MA 01887 (US)**

(72) Inventors:
• **RICHARDSON, Kenneth**
**Wilmington, 01887 (US)**
• **SCHNELL, Ryan**
**Wilmington, 01887 (US)**

(74) Representative: **Yang, Shu**
**Withers & Rogers LLP**
**2 London Bridge**
**London SE1 9RA (GB)**

(54) **SELECTIVE SOURCE DEGENERATION AS A CONTROL TECHNIQUE FOR POWER ELECTRONIC SWITCHES**

(57)    Various techniques are described to control the rate of change of current (di/dt) and the rate of change of voltage (dV/dt) for power electronic switches with conventional gate drivers and a few additional components. By implementing these techniques, designers may achieve better control over the switching behavior, reduce losses, and improve the overall reliability and efficiency of their circuits. This is particularly important in applications such as power inverters, where high performance and reliability are important.

FIG. 4

**Description**

This patent application claims the benefit of and priority to U.S. Non-Provisional Patent Application No. 18/904,733, filed on October 2, 2024.

**FIELD OF THE DISCLOSURE**

This document pertains generally, but not by way of limitation, to electronic circuits and, more particularly to gate driver circuits.

**BACKGROUND**

DC-DC converters are important components in modern electronic systems, enabling the efficient conversion of electrical power from one voltage level to another. These converters are widely used in applications ranging from portable electronic devices to large-scale industrial systems. The primary function of a DC-DC converter is to regulate the output voltage to a desired level while maintaining efficient power transfer. The two main types of DC-DC converters are step-down (buck) and step-up (boost) converters. Buck converters reduce the input voltage to a lower output voltage, whereas boost converters increase the input voltage to a higher output voltage. These converters utilize switching elements, inductors, capacitors, and control circuitry to achieve high efficiency and precise voltage regulation.

An important component in the operation of DC-DC converters is the gate driver. Gate drivers are specialized circuits that interface between the control logic and the power transistors used in the converter. The primary role of a gate driver is to provide the necessary voltage and current to switch the power transistors on and off rapidly and efficiently. This switching action is fundamental to the operation of the DC-DC converter, as it controls the timing and duration of current flow through the inductor, thereby regulating the output voltage. Gate drivers must be capable of delivering high peak currents to overcome the gate capacitance of power transistors and ensure fast switching times. Additionally, they often include features such as protection circuits, level shifting, and isolation to enhance reliability and performance in various applications.

**SUMMARY OF THE DISCLOSURE**

This disclosure describes various techniques to control the rate of change of current (di/dt) and the rate of change of voltage (dV/dt) for power electronic switches with conventional gate drivers and a few additional components. By implementing these techniques, designers may achieve better control over the switching behavior, reduce losses, and improve the overall reliability and efficiency of their circuits. This is particularly important in applications such as power inverters, where high performance and reliability are important.

In some aspects, this disclosure is directed to a power switching circuit configured for coupling with a gate driver circuit, the power switching circuit comprising: a transistor including: a first terminal configured for coupling with a load; a second terminal configured for coupling with an inductance; and a control terminal configured for coupling with the gate driver circuit; a switch; and a feedback circuit coupled with the switch and including at least one resistive element, wherein the switch is configured for coupling, based on a control signal, the feedback circuit with the gate driver circuit.

In some aspects, this disclosure is directed to a power switching circuit configured for coupling with a gate driver circuit, the power switching circuit comprising: a transistor including: a first terminal configured for coupling with a load; a second terminal configured for coupling with an inductance; and a control terminal configured for coupling with the gate driver circuit; a pair of Zener diodes, connected in opposition; and a feedback circuit coupled with the pair of Zener diodes and including at least one resistive element, wherein the feedback circuit is coupled with the gate driver circuit.

In some aspects, this disclosure is directed to a power switching circuit configured for coupling with a gate driver circuit, the power switching circuit comprising: a transistor including: a first terminal configured for coupling with a load; a second terminal configured for coupling with an inductance; and a control terminal configured for coupling with the gate driver circuit; a feedback circuit including at least one resistive element and at least one capacitive element, wherein the feedback circuit is configured for coupling with the gate driver circuit.

**BRIEF DESCRIPTION OF THE DRAWINGS**

In the drawings, which are not necessarily drawn to scale, like numerals may describe similar components in different views. Similar components in different views may be described by like numerals. The drawings illustrate generally, by way of example, but not by way of limitation, various embodiments discussed in the present document.

FIG. 1 is a schematic diagram of an example of a current control system that may implement various techniques of this disclosure.

FIG. 2 depicts an example of a power switching circuit, which may form a part of the current control system of FIG. 1.

FIG. 3 depicts another example of a power switching circuit, which may form a part of current control system of FIG. 1.

FIG. 4 depicts an example of a power switching circuit, which may form a part of the current control system of FIG. 1, and which implements various techniques of this disclosure

FIG. 5 depicts another example of a power switching circuit, which may form a part of the power switching circuit of FIG. 1, and which implements various techniques of this disclosure.

FIG. 6 depicts another example of a power switching circuit, which may form a part of the power switching circuit of FIG. 1, and which implements various techniques of this disclosure.

FIG. 7 depicts another example of a power switching circuit, which may form a part of the power switching circuit of FIG. 1, and which implements various techniques of this disclosure.

FIG. 8 depicts another example of a power switching circuit, which may form a part of the power switching circuit of FIG. 1, and which implements various techniques of this disclosure.

FIG. 9 depicts another example of a power switching circuit, which may form a part of the power switching circuit of FIG. 1, and which implements various techniques of this disclosure.

FIG. 10 depicts another example of a power switching circuit, which may form a part of the power switching circuit of FIG. 1, and which implements various techniques of this disclosure.

FIG. 11 depicts another example of a power switching circuit, which may form a part of the power switching circuit of FIG. 1, and which implements various techniques of this disclosure.

## DETAILED DESCRIPTION

Current series feedback, also known as source degeneration, is a widely employed method to enhance the characteristics of these components. In this technique, a series element is introduced into the circuit, which may be inductive in nature. The use of an inductive element is particularly beneficial as it reduces losses and provides control over the rate of change of current (di/dt). This control is important in managing the switching behavior of devices and minimizing unwanted effects.

One practical application of this technique is found within integrated circuit (IC) packages. Here, separate bond wires are strategically placed to divert currents from the driver stage away from the rest of the circuitry. This separation helps to isolate different parts of the circuit, reducing interference and improving overall performance.

In the context of power inverters, the paralleling of switch elements is a common practice to handle high currents. However, this parallelization may lead to very high di/dt values. When these rapid current changes interact with the inherent inductances present in the module, they may degrade the switching behavior of the devices. Moreover, these interactions may generate unintended transient voltages on the switching control nodes, such as the base or gate of transistors. These unintended voltages may cause various issues, including false triggering, increased switching losses, and potential damage to the devices. Therefore, careful consideration of these effects is important in the design of power electronic circuits, especially those involving high-speed switching and large currents.

During reverse recovery, the transient voltage could breakdown the control node in the reverse direction, and during turn off the series inductance could cause spurious turn on of the off path switch. The present inventors have recognized a need to solve these problems.

This disclosure describes various techniques to control the rate of change of current (di/dt) and the rate of change of voltage (dV/dt) for power electronic switches with conventional gate drivers and a few additional components. By implementing these techniques, designers may achieve better control over the switching behavior, reduce losses, and improve the overall reliability and efficiency of their circuits. This is particularly important in applications such as power inverters, where high performance and reliability are important.

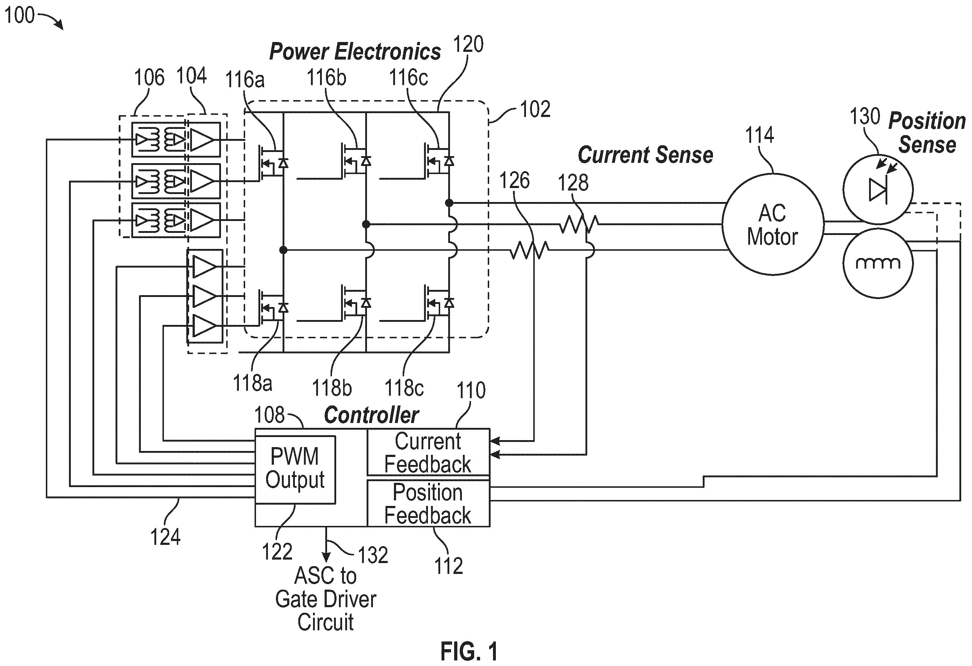

FIG. 1 is a schematic diagram of an example of current control system 100 that may implement various techniques of this disclosure. In the non-limiting example shown, the current control system 100 forms part of a motor drive signal chain, specifically designed for an alternating current (AC) motor. The current control system 100 includes a three-phase half-bridge circuit 102, gate driver circuits 104, isolator components 106, a controller 108 with a current feedback circuit 110 and a position feedback circuit 112, and sensors, all of which contribute to the precise and efficient operation of the AC motor 114.

The three-phase half-bridge circuit 102 includes six transistors (or "power switches"), namely the transistors 116a -116c and the transistors 118a-118c, arranged into three half-bridge configurations. Each half-bridge, e.g., the transistor 116a and the transistor 118a, is responsible for driving one phase of the AC motor 114. The controller 108 controls the transistors within these bridges to switch on and off in a synchronized manner, facilitating the precise control of electrical current flowing through the windings of the AC motor 114. This control is pivotal in managing the speed and torque of the AC motor 114.

Integral to the operation of the three-phase half-bridge circuit 102 are the gate driver circuits 104, which are coupled with the control terminals, e.g., gate terminals, of the transistors, such as Insulated Gate Bipolar Transistors (IGBTs) and Field-Effect Transistors (FETs). The gate driver circuits 104 provide the necessary drive voltage to actuate the transistors, ensuring efficient switching.

For the top half of the three-phase half-bridge circuit 102, which includes the transistors 116a -116c, isolator components 106 are coupled with a corresponding gate driver circuit 104. The transistors 116a -116c are coupled with a high voltage supply 120, such as coupled with a battery stack in an electric vehicle. In some examples, the high voltage supply 120 may be 400 volts or higher. The isolator components 106 electrically isolate the low-voltage control side of the gate drivers, such as the side coupled with the controller 108, from the high-voltage power side of the three-phase half-bridge circuit 102. Such isolation protects the controller 108 from high-voltage transients and facilitates safe signal transmission between the controller 108 and the gate driver circuit 104.

The controller 108 includes a Pulse Width Modulation (PWM) output circuit 122. The PWM output circuit 122 generates PWM output signals 124 directed to the gate driver circuit 104. The PWM output signals 124 modulate the duty cycle of the transistor switching, thereby controlling the power delivered to the windings of the AC motor 114. Additionally, the controller 108 is equipped with a current feedback circuit 110 and a position feedback circuit 112, which allow closed-loop control.

The current feedback circuit 110 is designed to receive input from a current sensor, such as formed by a current sense resistor 126 and a current sense resistor 128, which are positioned in two phases of the three-phase half-bridge circuit 102. The current feedback circuit 110, via the current sensor, monitors the current flowing through the windings of the AC motor 114, providing real-time feedback to the controller 108. Using this information, the controller 108 may adjust the PWM output signals 124 to ensure the AC motor 114 operates within desired parameters.

The current control system 100 also includes a position sensor 130, such as an optical sensor or a rotary encoder, coupled with the AC motor 114. The position sensor 130 provides precise feedback on the rotor position to the position feedback circuit 112 within the controller 108. Accurate position feedback is important for controlling the speed and position of the AC motor 114 with precision, enabling applications that demand exact motion control.

The current control system 100 is designed to couple each phase of the three-phase half-bridge circuit 102 with a winding in the AC motor 114, facilitating the conversion of electrical energy into mechanical motion. The inclusion of a current sensor and a position sensor provide the necessary feedback for the controller 108 to fine-tune the operation of the AC motor 114 in real-time, thereby optimizing performance and efficiency.

In a motor drive system, such as those implemented in electric vehicle traction drives, an alternating current motor, e.g., AC motor 114, is driven by a three-phase half-bridge circuit controlled by a system controller, e.g., the controller 108. The system controller enables each transistor of the three-phase half-bridge circuit with pulse width modulated patterns, such as generated by PWM output circuit 122. The delivered current from the three-phase half-bridge circuit into the inductance of the motor windings of the AC motor appears as a three-phase sine wave. A function of traction drive system controllers is to operate the motor safely and protect the system and maintain control on the vehicle in system shorts or vehicle accidents.

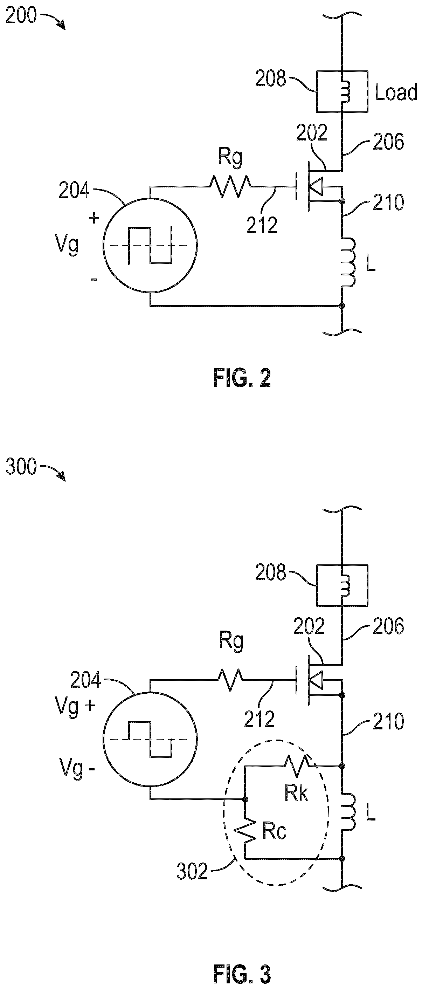

FIG. 2 depicts an example of a power switching circuit 200, which may form a part of the current control system 100 of FIG. 1. The power switching circuit 200 is configured for coupling with a gate driver circuit. A transistor 202, such as one of the transistors 116a -116c of FIG. 1, is coupled, via a resistive element Rg, to a gate driver circuit 204, such as one of the gate driver circuits 104 of FIG. 1.

A first terminal 206, e.g., drain terminal, is configured for coupling with a load 208, a second terminal 210, e.g., source terminal, is configured for coupling an inductance L, e.g., discrete and/or parasitic inductance, and a control terminal 212, e.g., gate terminal, configured for coupling with the gate driver circuit 204.

The use of a source inductance L and a gate resistive element Rg allows a first-order separation of the two switching parameters di/dt and dv/dt. This works because at turn-on and during turn-off, the input impedance of the combined transconductance and series inductance are a high impedance. Once the Miller plateau is reached, the di/dt term falls to 0 and the Miller characteristic takes over.

Relevant equations are shown below as Equations 1-4:

$$\frac{di}{dt_{ON}} \sim \left(V_{g+} - V_{th}\right)/L\left(R_K/\left(R_K + R_C\right)\right) \qquad \text{Equation 1}$$

$$\frac{di}{dt_{OFF}} \sim \left(V_{th} - \left(V_{g-}\right)/L\right) \qquad \text{Equation 2}$$

$$\frac{dv}{dt_{full}} \sim \left(V_{g+} - V_{miller}\right)/\left(R_g \times C_{gd}\right) \qquad \text{Equation 3}$$

$$\frac{dv}{dt_{OFF}} \sim \left(V_{miller} - \left(V_{g-}\right)/\left(R_g \times C_{gd}\right)\right) \qquad \text{Equation 4}$$

In Equations 1-4, $V_{miller}$ is the Miller voltage, $C_{gd}$ is the gate-to-drain capacitance, and $V_{th}$ is the threshold voltage.

FIG. 3 depicts another example of a power switching circuit 300, which may form a part of the current control system 100 of FIG. 1. The power switching circuit 300 is configured for coupling with a gate driver circuit. The power switching circuit 300 of FIG. 3 is similar to the power switching circuit 200 of FIG. 2 but further includes a voltage divider 302 formed by the resistive element $R_K$ and the resistive element $R_C$. The voltage divider 302 functions as di/dt control resistor divider.

The power switching circuit 300 shows how to increase the target di/dt by reducing the effective inductance and maintaining the approximate Kelvin impedance for good damping of the gate circuit. Relevant equations are shown below as Equations 5-8:

$$\frac{di}{dt_{ON}} \sim \left(V_{g+} - V_{th}\right)/L\left(R_K/\left(R_K + R_C\right)\right) \qquad \text{Equation 5}$$

$$\frac{di}{dt_{OFF}} \sim \left(V_{th} - \left(V_{g-}\right)/L\left(R_K/\left(R_K + R_C\right)\right)\right) \qquad \text{Equation 6}$$

$$\frac{dv}{dt_{full}} \sim \left(V_{g+} - V_{miller}\right)/\left(\left(R_g + R_{eq}\right) \times C_{gd}\right) \qquad \text{Equation 7}$$

$$\frac{dv}{dt_{OFF}} \sim \left(V_{miller} - \left(V_{g-}\right)/\left(\left(R_g + R_{eq}\right) \times C_{gd}\right)\right) \qquad \text{Equation 8}$$

In Equations 5-8, $V_{miller}$ is the Miller voltage, $C_{gd}$ is the gate-to-drain capacitance, $V_{th}$ is the threshold voltage, and Req is the equivalent resistance of resistive element $R_K$ in parallel with resistive element $R_C$.

As shown and described in detail below, this disclosure describes the use of feedback to control di/dt and dV/dt for power electronics switches with conventional gate drivers and a few additional components. In some examples, an auxiliary switch is included, which allows the use of package inductance for control.

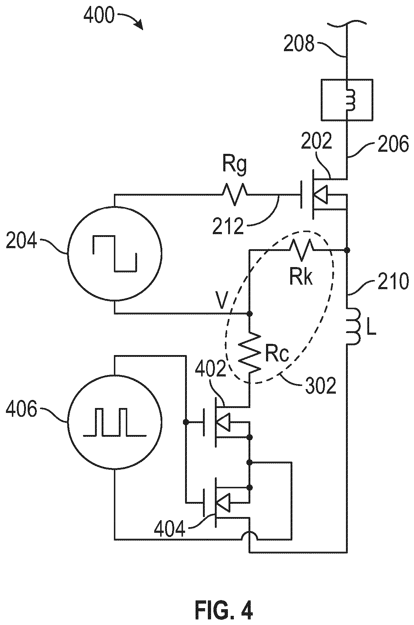

FIG. 4 depicts an example of a power switching circuit 400, which may form a part of the power switching circuit of FIG. 1, and which implements various techniques of this disclosure. The power switching circuit 400 is configured for coupling with a gate driver circuit.

A transistor 202, such as one of the transistors 116a -116c of FIG. 1, is coupled, via a resistive element Rg, to a gate driver circuit 204, such as one of the gate driver circuits 104 of FIG. 1. A first terminal 206, e.g., drain terminal, is configured for coupling with a load 208, a second terminal 210, e.g., source terminal, is configured for coupling an inductance L, e.g., discrete and/or parasitic inductance, and a control terminal 212, e.g., gate terminal, configured for coupling with the gate driver circuit 204. The power switching circuit 400 further includes a voltage divider 302 formed by the resistive element $R_K$ and the resistive element $R_C$. The resistive element $R_K$ is coupled with the second terminal 210.

The voltage divider 302 functions as di/dt control resistor divider.

Using the techniques of this disclosure, one or more electronic switches are included in the power switching circuit 400, such as the transistor 402 and/or the transistor 404. The transistor 402 and the transistor 404 are coupled with another gate driver circuit 406.

The power switching circuit 400 includes a feedback circuit coupled with a switch. The feedback circuit includes the resistive element $R_K$ and the resistive element $R_C$ and feeds back a voltage V to the gate driver circuit 204. The switch, e.g., a bidirectional switch including both the transistor 402 and the transistor 404, is configured for coupling, based on a control signal from the gate driver circuit 406, the feedback circuit with the gate driver circuit 204. The switch is coupled with the resistive element $R_C$. It should also be noted that the switch location may be moved to the other end of the resistive element $R_C$, or the resistive element $R_C$ may be split.

Using these techniques, the power switching circuit 400 selectively activates and deactivates feedback within the system, which is achieved using an electronic switch, which allows for precise control over when feedback occurs in the system, such as to limit the di/dt control to the switching transitions. For turn on, the switch may be closed at roughly the same time as the gate drive pulse, and may be released at a time slightly greater than the max-current target divided by the target di/dt. Or, for the main switch, e.g., the transistor 202, turn-on transition, the auxiliary switch, e.g., the transistor 402 and the transistor 404, turn-off may be timed with gate sense.

During main switch turn-off at the gate turn-off transition, the auxiliary switch may be closed and held for a fixed time sufficient to turn off the switch, and may be released towards the end of the dead time interval. During the first part of the turn-off, the dV/dt limiting by the gate resistive element precedes the di/dt limiting operation. Gate sensing may also be used to time the auxiliary switch release.

The circuit incorporates a gate driver, represented in the diagram as a circle containing a waveform. This gate driver is responsible for providing switching signals to the main power transistor 202. The gate driver typically outputs either a high voltage (around +15V) or a low voltage (around -5V) to control the switching state of the transistor 202.

When the gate driver circuit 204 is commanded to turn on, the gate voltage begins to rise. As the gate voltage increases, it eventually reaches a point where current starts to flow through the main switch, e.g., the transistor 202. This current flow creates a change in current over time (di/dt) in the inductor L. The voltage across the inductor is governed by the equation $V = L * di/dt$. As current flows, a voltage develops across the inductor L, raising the potential at one end. The voltage source, which provides either +15V or -5V, switches to the +15V state during turn-on.

Some voltage drop occurs across the resistive element $R_K$ due to the large gate capacitance of the transistor 202. The gate voltage of the transistor 202 rises to a level slightly above its threshold voltage, typically around 3-4V. As current flows through the transistor 202, it generates a di/dt in the inductor L. This creates a voltage across the inductor L with a specific polarity: the top node (connected to the voltage source) becomes positive, while the bottom node becomes negative. This negative voltage at the bottom of the inductor L opposes the +15V gate drive voltage. As a result of this opposing voltage, the current flowing into the gate of the transistor 202 begins to decrease.

This self-regulating effect helps maintain a constant di/dt during the switching transition, which is a key feature of the feedback mechanism in this design. This continues until the target current is reached, at which point di/dt rapidly approaches zero, and the feedback effect naturally diminishes.

The auxiliary switch, e.g., the transistor 402 and the transistor 404, is closed and held in a conductive state for a fixed duration that is sufficient to cover the turn-on or turn-off transition of the main switch, e.g., the transistor 202. The timing of the operation of the auxiliary switch is carefully controlled to align with the switching events of the main switch. Specifically, in some examples, the auxiliary switch is opened towards the end of the dead time interval, which is the period when both the upper and lower switches in a typical power converter configuration are intentionally in an off state to prevent shoot-through currents.

This innovative approach to switch control and feedback offers potential improvements in switching performance, potentially reducing losses and improving overall efficiency in power electronic systems. The ability to selectively engage the feedback mechanism provides a new level of control that could be particularly beneficial in applications requiring precise management of switching transients.

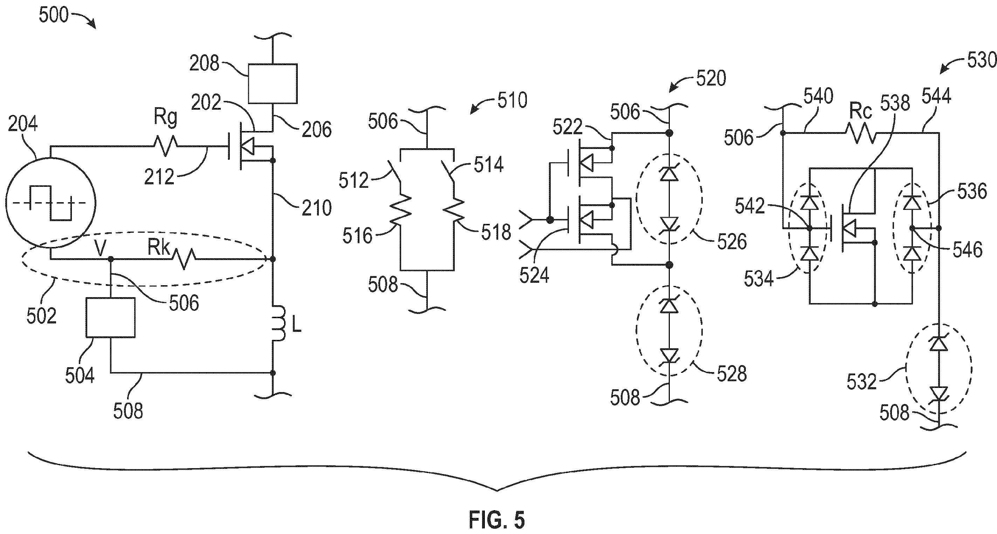

FIG. 5 depicts another example of a power switching circuit 500, which may form a part of the power switching circuit of FIG. 1, and which implements various techniques of this disclosure. The power switching circuit 500 is configured for coupling with a gate driver circuit.

A transistor 202, such as one of the transistors 116a -116c of FIG. 1, is coupled, via a resistive element Rg, to a gate driver circuit 204, such as one of the gate driver circuits 104 of FIG. 1. A first terminal 206, e.g., drain terminal, is configured for coupling with a load 208, a second terminal 210, e.g., source terminal, is configured for coupling an inductance L, e.g., discrete and/or parasitic inductance, and a control terminal 212, e.g., gate terminal, configured for coupling with the gate driver circuit 204.

The power switching circuit 500 includes a feedback circuit 502 including the resistive element $R_K$, where the resistive element $R_K$ is coupled with the second terminal 210. The feedback circuit 502 is coupled with a network 504. The network 504 is coupled between the node 506 and the node 508, where the node 506 is between the gate driver circuit 204 and the resistive element $R_K$, and where the node 508 is coupled with the inductance L.

A first example of the network 504 is the network 510 coupled between the node 506 and the node 508. The network 510 includes a first electronic switch 512 and a second electronic switch 514. A first resistive element 516 is coupled in series with the first switch 512 and forms a first path, and a second resistive element 518 is coupled in series with the second switch 514 and forms a second path, where the first path is in parallel with the second path. The feedback circuit 502 is coupled with the network 510. The first switch 512 and the second switch 514 are configured for coupling, based on control signals, the feedback circuit with the gate driver circuit 204.

A second example of the network 504 is the network 520 coupled between the node 506 and the node 508. The network 520 includes a first electronic switch 522 and a second electronic switch 524, e.g., transistors, such as arranged as a bidirectional switch. The network 520 further includes a first pair of Zener diodes 526, connected in opposition, and a second pair of Zener diodes 528, connected in opposition. The first pair of Zener diodes 526 is connected in series with the second pair of Zener diodes 528. The bidirectional switch formed by the first electronic switch 522 and the second electronic switch 524 is connected in parallel with the first pair of Zener diodes 526. The feedback circuit 502 is coupled with the network 520. The first electronic switch 522 and the second electronic switch 524 are configured for coupling, based on control signals, the feedback circuit 502 with the gate driver circuit 204.

A third example of the network 504 is the network 530 coupled between the node 506 and the node 508. The network 530 includes the resistive element $R_C$ coupled in series with a pair of Zener diodes 532, where the pair of Zener diodes 532 are connected in opposition. In addition, the network 530 includes a first pair of diodes 534, connected in opposition, and a second pair of diodes 536, connected in opposition. The first pair of diodes 534 is connected in parallel with the second pair of diodes 536. In addition, the network 530 includes an electronic switch 538 connected in parallel with the first pair of diodes 534 and the second pair of diodes 536. A first terminal 206 of resistive element $R_C$ is coupled to a node 542 between the first pair first pairs of diodes 534, and a second terminal 544 of the resistive element $R_C$ is coupled to a node 546 between the second pair of diodes 536. The switch 538 is configured for coupling, based on a control signal, the feedback circuit 502 with the gate driver circuit 204.

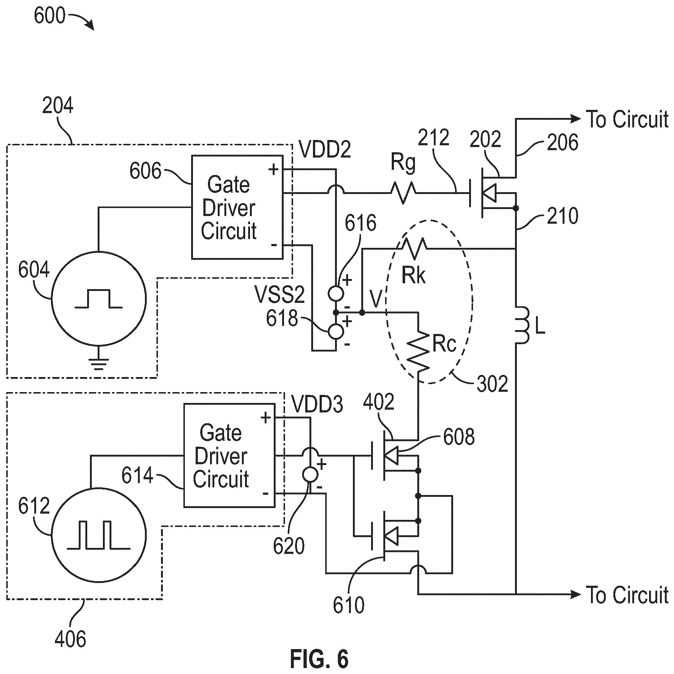

FIG. 6 depicts another example of a power switching circuit 600, which may form a part of the power switching circuit of FIG. 1, and which implements various techniques of this disclosure. The power switching circuit 600 is configured for coupling with a gate driver circuit.

The gate driver circuit 204 is shown as including a voltage source 604 and a gate driver circuit 606. Like before, the control terminal 212 is coupled to the gate driver circuit 204 via a resistive element $R_G$. The power switching circuit 600 includes a feedback circuit coupled with a switch, e.g., a bidirectional switch including both the transistor 608 and the transistor 610. The feedback circuit includes the resistive element $R_K$ and the resistive element $R_C$ and feeds back a voltage V to the gate driver circuit 204.

The power switching circuit 600 further includes a gate driver circuit 406, such as including a voltage source 612 and a gate driver circuit 614. The switch, e.g., a bidirectional switch including both the transistor 608 and the transistor 610, is configured for coupling, based on control signals from the gate driver circuit 614, the feedback circuit with the gate driver circuit 204. The switch is coupled with the resistive element $R_C$. The switch opens or shorts the feedback circuit.

The power switching circuit 600 includes a first voltage source 616 and a second voltage source 618. The first voltage source 616 includes a positive terminal + and a negative terminal -, where the positive terminal + of the first voltage source 616 is configured for coupling with a positive terminal + of the gate driver circuit 606. The second voltage source 618 includes a positive terminal + and a negative terminal -, where the negative terminal - of the second voltage source 618 is configured for coupling with a negative terminal - of the gate driver circuit 606. The positive terminal + of the second voltage source 618 is coupled with the negative terminal - of the first voltage source 616 and the resistive element $R_K$.

A third voltage source 620 includes a positive terminal + and a negative terminal -, where the positive terminal + of the third voltage source 620 is configured for coupling with a positive terminal + of the gate driver circuit 614, and where the negative terminal - of the third voltage source 620 is configured for coupling with a negative terminal - of the gate driver circuit 614.

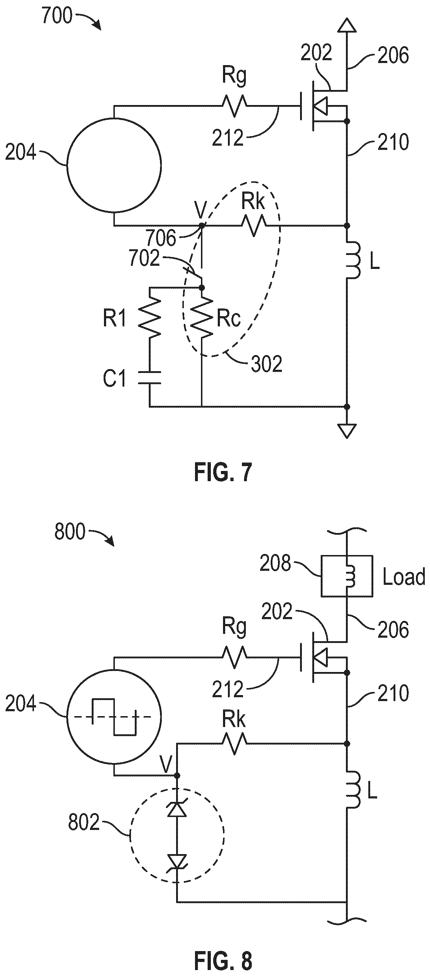

FIG. 7 depicts another example of a power switching circuit 700, which may form a part of the power switching circuit of FIG. 1, and which implements various techniques of this disclosure. The power switching circuit 700 is configured for coupling with a gate driver circuit.

The power switching circuit 700 is configured for coupling with a gate driver circuit 204 and includes a voltage divider 302 formed by the resistive element $R_K$ and the resistive element $R_C$. The power switching circuit 700 optionally includes a switch 702, e.g., a bidirectional switch such as in FIG. 4, coupled to the resistive element $R_C$.

The present inventors have recognized the desirability of including at least a capacitive element $C_1$ coupled in parallel with the resistive element $R_C$, such as for compensation. The capacitive element $C_1$ forms part of the feedback circuit to the gate driver circuit 204. In some examples, a resistive element $R_1$ is coupled in series with the capacitive element $C_1$ to form an RC pair, where the RC pair is coupled in parallel with the resistive element $R_C$.

The optional switch 702 is coupled with the gate driver circuit 204. In some examples, the resistive element $R_K$ and the resistive element $R_C$ form a voltage divider 302, where the resistive element $R_K$ is coupled with the second terminal 210, and where the switch 702 is coupled with a node 706 between the gate driver circuit 204, the resistive element $R_K$, and the resistive element $R_C$.

FIG. 8 depicts another example of a power switching circuit 800, which may form a part of the power switching circuit of FIG. 1, and which implements various techniques of this disclosure. The power switching circuit 800 is configured for coupling with a gate driver circuit.

A transistor 202, such as one of the transistors 116a -116c of FIG. 1, is coupled, via a resistive element Rg, to a gate driver circuit 204, such as one of the gate driver circuits 104 of FIG. 1.

A first terminal 206, e.g., drain terminal, is configured for coupling with a load 208, a second terminal 210, e.g., source terminal, is configured for coupling an inductance L, e.g., discrete and/or parasitic inductance, and a control terminal 212, e.g., gate terminal, configured for coupling with the gate driver circuit 204.

The present inventors have recognized that alternative techniques exist to adjust the gate voltage using feedback from the inductance L, such as with Zener diodes. In contrast to the example shown above in FIG. 4, for example, the power switching circuit 800 includes a pair of Zener diodes 802 connected in opposition. The power switching circuit 800 includes a feedback circuit coupled with the pair of Zener diodes 802. The feedback circuit includes the resistive element $R_K$ and feeds back a voltage V to the gate driver circuit 204. The equation for the di/dt is shown below in Equation 9:

$$\frac{di}{dt_{ON}} \sim \left( (V_{g+} - V_{th}) + V_Z \right)/L \qquad \text{Equation 9}$$

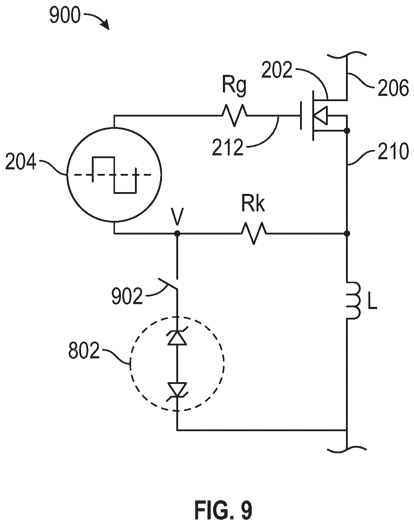

FIG. 9 depicts another example of a power switching circuit 900, which may form a part of the power switching circuit of FIG. 1, and which implements various techniques of this disclosure. The power switching circuit 900 is configured for coupling with a gate driver circuit.

The power switching circuit 900 of FIG. 9 is similar to the power switching circuit 800 of FIG. 8, but further includes a switch 902. The feedback circuit, which includes the resistive element $R_K$ and feeds back a voltage V to the gate driver circuit 204, is coupled with the switch 902. In some examples, the switch 902 is a bidirectional switch, such as shown in FIG. 4 with the use of the transistor 402 and the transistor 404. The switch 902 is configured for coupling, based on a control signal, such as from the gate driver circuit 406 of FIG. 4, the feedback circuit with the gate driver circuit 204.

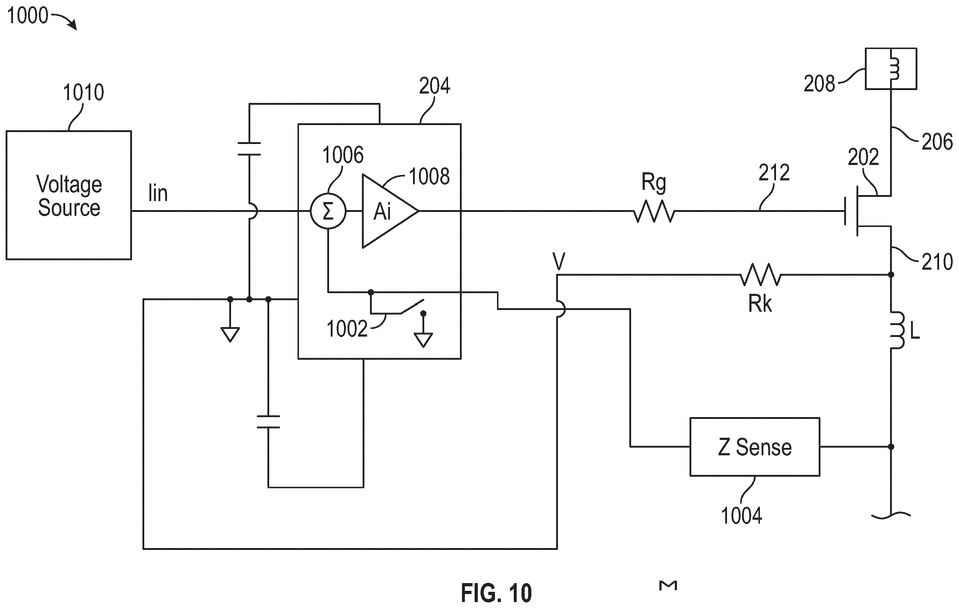

FIG. 10 depicts another example of a power switching circuit 1000, which may form a part of the power switching circuit of FIG. 1, and which implements various techniques of this disclosure. The power switching circuit 1000 is configured for coupling with a gate driver circuit.

A transistor 202, such as one of the transistors 116a -116c of FIG. 1, is coupled, via a resistive element Rg, to a gate driver circuit 204, such as one of the gate driver circuits 104 of FIG. 1. A first terminal 206, e.g., drain terminal, is configured for coupling with a load 208, a second terminal 210, e.g., source terminal, is configured for coupling an inductance L, e.g., discrete and/or parasitic inductance, and a control terminal 212, e.g., gate terminal, configured for coupling with the gate driver circuit 204.

In contrast to the examples described above, the power switching circuit 1000 includes a switch 1002 integrated inside the gate driver circuit 204 integrated circuit (IC). The feedback circuit, which includes the resistive element $R_K$ and feeds back a voltage V to the gate driver circuit 204, is coupled with the switch 1002. In some examples, the switch 1002 is a bidirectional switch, such as shown in FIG. 4 with the use of the transistor 402 and the transistor 404. The switch 1002 is configured for coupling, based on a control signal, such as from the gate driver circuit 406 of FIG. 4, the feedback circuit with the gate driver circuit 204.

The Z sense circuit 1004 represents a variation on the feedback circuit described above. The Z sense circuit 1004 may include the resistive element $R_C$ in previous figures or configurations of resistive elements and capacitive elements, such as described earlier. In the power switching circuit 1000, a higher impedance element, namely the Z sense circuit 1004, is coupled to a pin on the gate driver circuit 204 that is separate from the main power path, which is the path from the voltage source 1010 through the gate driver circuit 204 and gate resistor $R_G$ to the control terminal 212, e.g., the transistor gate. In contrast, previous examples, such as FIG. 4, depict the resistive element $R_C$ coupled with a node in the main power path, such as the node between the resistive element $R_K$ and the resistive element $R_C$.

The higher impedance of the Z sense circuit 1004 makes the Integration of the switch 1002 within the gate driver circuit 204 IC possible. This circuit's impedance allows the switch 1002 to handle high voltages while limiting current flow. The switch 1002 may operate at lower voltages, making it suitable for integration within the IC.

The Z sense circuit 1004 couples to a control input on the gate driver circuit 204 IC, interfacing with internal components, such as a summing circuit 1006 coupled with an input to an amplifier 1008. The summing circuit 1006 combines the Z sense input with other control signals within the gate driver circuit 204 IC. The integrated switch 1002 may then selectively control feedback to the gate driver circuit 204 or other functions within the gate driver circuit all while maintaining isolation from the main power path. This approach offers several advantages, including a reduced external part count and increased functionality within the gate driver circuit IC.

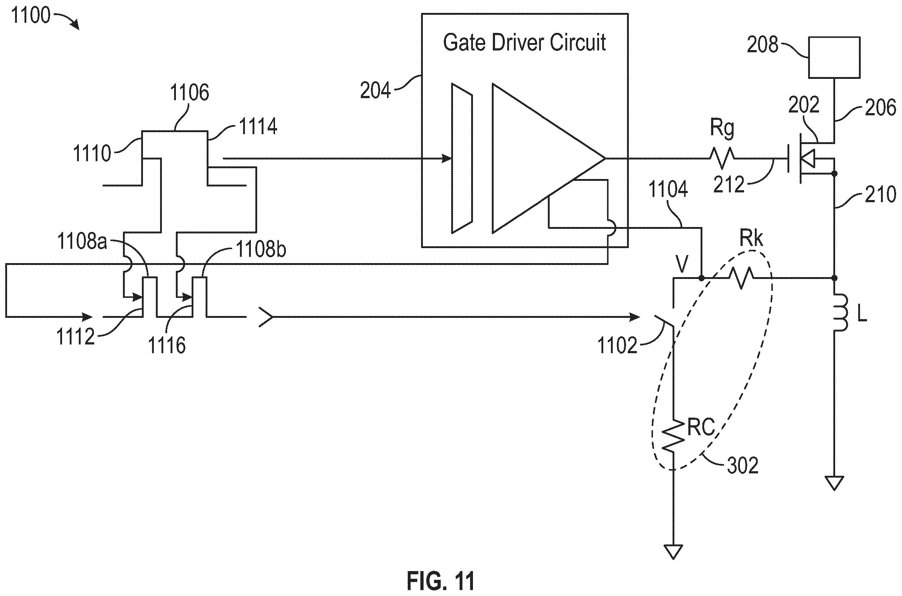

FIG. 11 depicts another example of a power switching circuit 1100, which may form a part of the power switching circuit of FIG. 1, and which implements various techniques of this disclosure. The power switching circuit 1100 is configured for coupling with a gate driver circuit 204 and includes a voltage divider 302 formed by the resistive element $R_K$ and the resistive element $R_C$. The power switching circuit 1100 includes a switch 1102, e.g., a bidirectional switch such as in FIG. 4, coupled with the resistive element $R_C$ and with a node 1104, where the node is coupled with the resistive element $R_K$ and the gate driver circuit 204.

The switch 1102 is coupled with the gate driver circuit 204. In some examples, the resistive element $R_K$ and the resistive element $R_C$ form a voltage divider 302, where the resistive element $R_K$ is coupled with the second terminal 210.

As shown in FIG. 11, a pulse 1106, such as generated by the PWM output circuit 122 of FIG. 1, is received by the gate driver circuit 204. The gate driver circuit 204 generates auxiliary pulse 1108a and auxiliary pulse 1108b, where the pulse 1106 controls the transistor 202 and the auxiliary pules control the switch 1102. In the example shown, the rising edge 1110 of the pulse 1106 corresponds with a rising edge 1112 of the auxiliary pulse 1108a, and the falling edge 1114 of the rising edge 1110 corresponds with the rising edge 1116 of the subsequent auxiliary pulse 1108b.

The timing of pulse 1112 is as follows, on the PWM signal rising edge 1110, the rising edge of pulse 1112 is generated. Pulse 1112 is held active (high in this case) until either a fixed time (one shot timer) determined by circuit elements in the power path, or in some embodiments, until additional sensing elements used to determine when the switching transients warrant ending trigger the off edge. Feedback in the aux sensing case is by use of common circuit techniques, such as measuring the inductor voltage (proportional to di/dt) against an internal threshold in the timing generator/gate driver. Similarly, the timing of pulse 1116 is initiated by the falling edge of the PWM signal 1114, and also similarly, the off edge of pulse 1116 may be a predetermined delay, or by means of a measured threshold as previously described.

The timing of pulses 1112 and 1116 may also be generated based on the state information of the intended switching element in the half-bridge. In modern inverter control schemes, a digital signal processor or a dedicated firmware/software programmed micro-controller may generate the PWM control signals directly based on the input commands to the inverter and sensor inputs from the inverter, such as the load current and voltage, switching element telemetry such as overshoot and temperature, and the power inputs to the inverter, typically the bus voltage and current. In a control system like this, pulses 1112 and 1116 may be generated directly as part of the overall PWM operation.

It may also be appreciated that the turn-off timing may extend into the switching cycle of the complementary switch in a half-bridge, where the di/dt or dV/dt control is active during reverse recovery, providing that the power stage designer has accounted for the switching transients and the possibility of controlling the off-state switch as the complementary switch (the other half of the half-bridge) assumes the load current. A short pulse of current into the gate may be desired as the high di/dt from reverse recovery can contribute to overshoot, and with some switching devices quick control of the gate by the di/dt feedback circuit can help control the overshoot.

## Various Notes

Each of the non-limiting claims or examples described herein may stand on its own, or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more claims thereof), either with respect to a particular example (or one or more claims thereof), or with respect to other examples (or one or more claims thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more claims thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

Numbered aspects

By way of non-limiting example, some aspects of the disclosure are set out in the following numbered clauses.

Numbered Clause 1. A power switching circuit configured for coupling with a gate driver circuit, the power switching circuit comprising:
a transistor including:

a first terminal configured for coupling with a load;
a second terminal configured for coupling with an inductance; and
a control terminal configured for coupling with the gate driver circuit;
a switch; and
a feedback circuit coupled with the switch and including at least one resistive element, wherein the switch is configured for coupling, based on a control signal, the feedback circuit with the gate driver circuit.

Numbered Clause 2. The power switching circuit of Numbered Clause 1, wherein the at least one resistive element includes a first resistive element and a second resistive element, wherein the first resistive element and the second resistive element form a voltage divider, wherein the first resistive element is coupled with the second terminal, and wherein the switch is coupled with the second resistive element.

Numbered Clause 3. The power switching circuit of Numbered Clause 2, wherein the switch is a bidirectional switch.

Numbered Clause 4. The power switching circuit of Numbered Clause 3, wherein the bidirectional switch includes a first transistor and a second transistor.

Numbered Clause 5. The power switching circuit of Numbered Clause 4, comprising:

a first pair of Zener diodes, connected in opposition;
a second pair of Zener diodes, connected in opposition, wherein the first pair of Zener diodes is connected in series with the second pair of Zener diodes, and wherein the bidirectional switch is connected in parallel with the first pair of Zener diodes.

Numbered Clause 6. The power switching circuit of any preceding Numbered Clause, wherein the switch is a first switch, the power switching circuit further comprising:

a first resistive element coupled in series with the first switch and forming a first path; and
a second switch coupled in series with a second resistive element and forming a second path, wherein the first path is in parallel with the second path.

Numbered Clause 7. The power switching circuit of any preceding Numbered Clause, wherein the at least one resistive element includes a first resistive element and a second resistive element, the power switching circuit comprising:

a first pair of diodes, connected in opposition;
a second pair of diodes, connected in opposition, wherein the first pair of diodes is connected in parallel with the second pair of diodes, and wherein the switch is connected in parallel with the first pair of diodes and the second pair of diodes; and
a pair of Zener diodes, connected in opposition, wherein the second resistive element is coupled in series with the pair of Zener diodes, wherein a first terminal of the second resistive element is coupled to a node between the first pair of diodes, wherein a second terminal of the second resistive element is coupled to a node between the second pair of diodes.

Numbered Clause 8. The power switching circuit of any of Numbered Clauses 3 to 7, comprising:

a first voltage source having a positive terminal and a negative terminal,
wherein the positive terminal of the first voltage source is configured for coupling with a positive terminal of the gate driver circuit;
a second voltage source having a positive terminal and a negative terminal, wherein the negative terminal of the second voltage source is configured for coupling with a negative terminal of the gate driver circuit, wherein the positive terminal of the second voltage source is coupled with the negative terminal of the first voltage source and the first resistive element.

Numbered Clause 9. The power switching circuit of any preceding Numbered Clause, wherein the at least one resistive element includes a first resistive element and a second resistive element, wherein the feedback circuit further includes:
at least a capacitive element coupled in parallel with the second resistive element.

Numbered Clause 10. The power switching circuit of any preceding Numbered Clause, wherein the at least one resistive element includes a first resistive element and a second resistive element, wherein the feedback circuit further includes:
a third resistive element coupled in series with a capacitive element to form an RC pair, wherein the RC pair is coupled in parallel with the second resistive element.

Numbered Clause 11. A power switching circuit configured for coupling with a gate driver circuit, the power switching circuit comprising:
a transistor including:

a first terminal configured for coupling with a load;
a second terminal configured for coupling with an inductance; and
a control terminal configured for coupling with the gate driver circuit;
a pair of Zener diodes, connected in opposition; and
a feedback circuit coupled with the pair of Zener diodes and including at least one resistive element, wherein the feedback circuit is coupled with the gate driver circuit.

Numbered Clause 12. The power switching circuit of Numbered Clause 11, comprising:
a switch, wherein the feedback circuit is coupled with the switch, and wherein the switch is configured for coupling, based on a control signal, the feedback circuit with the gate driver circuit.

Numbered Clause 13. The power switching circuit of Numbered Clause 12, wherein the switch is internal to the gate driver circuit.

Numbered Clause 14. A power switching circuit configured for coupling with a gate driver circuit, the power switching circuit comprising:

a transistor including:

a first terminal configured for coupling with a load;
a second terminal configured for coupling with an inductance; and
a control terminal configured for coupling with the gate driver circuit;
a feedback circuit including at least one resistive element and at least one capacitive element, wherein the feedback circuit is configured for coupling with the gate driver circuit.

Numbered Clause 15. The power switching circuit configured of Numbered Clause 14, wherein the at least one resistive element and the at least one capacitive element includes:

a first resistive element coupled in series with a first capacitive element; and
a second resistive element coupled in parallel with the first resistive element and the first capacitive element.

Numbered Clause 16. The power switching circuit configured of Numbered Clause 15, comprising:

a switch coupled with the gate driver circuit,
wherein the at least one resistive element includes a first resistive element and a second resistive element, wherein the first resistive element and the second resistive element form a voltage divider, wherein the first resistive element is coupled with the second terminal, and wherein the switch is coupled with a node between the gate driver circuit, the first resistive element, and the second resistive element.

Numbered Clause 17. A power switching circuit configured for coupling with a first gate driver circuit, the power switching circuit comprising:
a transistor including:

a first terminal configured for coupling with a load;
a second terminal configured for coupling with an inductance; and
a control terminal configured for coupling with the gate driver circuit;
a bidirectional switch including a first transistor and a second transistor;
a second gate driver circuit coupled with the first transistor and the second transistor, second gate driver circuit configured for generating control signals to the first transistor and the second transistor; and
a feedback circuit coupled with the bidirectional switch and including at least one resistive element, wherein the bidirectional switch is configured for coupling, based on the control signals, the feedback circuit with the first gate driver circuit.

Numbered Clause 18. The power switching circuit configured of Numbered Clause 17, wherein the at least one resistive element includes a first resistive element and a second resistive element, wherein the first resistive element and the second resistive element form a voltage divider, wherein the first resistive element is coupled with the second terminal, and wherein the switch is coupled with the second resistive element.

Numbered Clause 19. The power switching circuit configured of Numbered Clause 17 or 18, comprising:

a first pair of Zener diodes, connected in opposition;

a second pair of Zener diodes, connected in opposition, wherein the first pair of Zener diodes is connected in series with the second pair of Zener diodes, and wherein the bidirectional switch is connected in parallel with the first pair of Zener diodes.

Numbered Clause 20. The power switching circuit configured of any of Numbered Clauses 17 to 19, wherein the at least one resistive element includes a first resistive element and a second resistive element, the power switching circuit comprising:

a first pair of diodes, connected in opposition;
a second pair of diodes, connected in opposition, wherein the first pair of diodes is connected in parallel with the second pair of diodes, and wherein the switch is connected in parallel with the first pair of diodes and the second pair of diodes; and
a pair of Zener diodes, connected in opposition, wherein the second resistive element is coupled in series with the pair of Zener diodes, wherein a first terminal of the second resistive element is coupled to a node between the first pair of diodes, wherein a second terminal of the second resistive element is coupled to a node between the second pair of diodes.

**Claims**

1. A power switching circuit configured for coupling with a gate driver circuit, the power switching circuit comprising:

   a transistor including:

   a first terminal configured for coupling with a load;
   a second terminal configured for coupling with an inductance; and
   a control terminal configured for coupling with the gate driver circuit;

   a switch; and
   a feedback circuit coupled with the switch and including at least one resistive element, wherein the switch is configured for coupling, based on a control signal, the feedback circuit with the gate driver circuit.

2. The power switching circuit of claim 1, wherein the at least one resistive element includes a first resistive element and a second resistive element, wherein the first resistive element and the second resistive element form a voltage divider, wherein the first resistive element is coupled with the second terminal, and wherein the switch is coupled with the second resistive element.

3. The power switching circuit of claim 2, wherein the switch is a bidirectional switch.

4. The power switching circuit of claim 3, wherein the bidirectional switch includes a first transistor and a second transistor.

5. The power switching circuit of claim 4, comprising:

   a first pair of Zener diodes, connected in opposition;
   a second pair of Zener diodes, connected in opposition, wherein the first pair of Zener diodes is connected in series with the second pair of Zener diodes, and
   wherein the bidirectional switch is connected in parallel with the first pair of Zener diodes.

6. The power switching circuit of any preceding claim, wherein the switch is a first switch, the power switching circuit further comprising:

   a first resistive element coupled in series with the first switch and forming a first path; and
   a second switch coupled in series with a second resistive element and forming a second path, wherein the first path is in parallel with the second path.

7. The power switching circuit of any preceding claim, wherein the at least one resistive element includes a first resistive element and a second resistive element, the power switching circuit comprising:

   a first pair of diodes, connected in opposition;
   a second pair of diodes, connected in opposition, wherein the first pair of diodes is connected in parallel with the second pair of diodes, and wherein the switch is connected in parallel with the first pair of diodes and the second pair of diodes; and
   a pair of Zener diodes, connected in opposition, wherein the second resistive element is coupled in series with the pair of Zener diodes, wherein a first terminal of the second resistive element is coupled to a node between the first pair of diodes, wherein a second terminal of the second resistive element is coupled to a node between the second pair of diodes.

8. The power switching circuit of any of claims 3 to 7, comprising:

   a first voltage source having a positive terminal and a negative terminal, wherein the positive terminal of the first voltage source is configured for coupling with a positive terminal of the gate driver circuit; a second voltage source having a positive terminal and a negative terminal, wherein the negative terminal of the second voltage source is configured for coupling with a negative terminal of the gate driver circuit, wherein the positive terminal of the second voltage source is coupled with the negative terminal of the first voltage source and the first resistive element.

9. The power switching circuit of any preceding claim, wherein the at least one resistive element includes a first resistive element and a second resistive element, wherein the feedback circuit further includes:
at least a capacitive element coupled in parallel with the second resistive element.

10. The power switching circuit of any preceding claim, wherein the at least one resistive element includes a first resistive element and a second resistive element, wherein the feedback circuit further includes:
a third resistive element coupled in series with a capacitive element to form an RC pair, wherein the RC pair is coupled in parallel with the second resistive element.

11. A power switching circuit configured for coupling with a gate driver circuit, the power switching circuit comprising:

   a transistor including:

      a first terminal configured for coupling with a load;
      a second terminal configured for coupling with an inductance; and
      a control terminal configured for coupling with the gate driver circuit;

   a pair of Zener diodes, connected in opposition; and
   a feedback circuit coupled with the pair of Zener diodes and including at least one resistive element, wherein the feedback circuit is coupled with the gate driver circuit.

12. The power switching circuit of claim 11, comprising:
a switch, wherein the feedback circuit is coupled with the switch, and wherein the switch is configured for coupling, based on a control signal, the feedback circuit with the gate driver circuit.

13. The power switching circuit of claim 12, wherein the switch is internal to the gate driver circuit.

14. A power switching circuit configured for coupling with a gate driver circuit, the power switching circuit comprising:

   a transistor including:

      a first terminal configured for coupling with a load;
      a second terminal configured for coupling with an inductance; and
      a control terminal configured for coupling with the gate driver circuit;

   a feedback circuit including at least one resistive element and at least one capacitive element, wherein the feedback circuit is configured for coupling with the gate driver circuit.

15. The power switching circuit configured of claim 14, wherein the at least one resistive element and the at least one capacitive element includes:

   a first resistive element coupled in series with a first capacitive element; and
   a second resistive element coupled in parallel with the first resistive element and the first capacitive element,

   preferably further comprising:

   a switch coupled with the gate driver circuit,
   wherein the at least one resistive element includes a first resistive element and a second resistive element, wherein the first resistive element and the second resistive element form a voltage divider, wherein the first resistive element is coupled with the second terminal, and wherein the switch is coupled with a node between the gate driver circuit, the first resistive element, and the second resistive element.

**FIG. 1**

200

208 Load

Rg

204

Vg

202 206

212

210

L

+

-

**FIG. 2**

300

208

202 206

Rg

204
Vg +

212

210

Vg -

Rk

Rc

L

302

**FIG. 3**

FIG. 4

**FIG. 5**

EP 4 723 481 A2

FIG. 6

FIG. 7

FIG. 8

FIG. 9

**FIG. 10**

EP 4 723 481 A2

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 90473324